# EUROPÄISCHE PATENTSCHRIFT

(11) **EP 2 965 382 B1**
(45) Veröffentlichungstag und Bekanntmachung des Hinweises auf die Patenterteilung: **19.10.2016**
(21) Anmeldenummer: 14700353.7
(22) Anmeldetag: 10.01.2014
(51) Int. Cl.: H01Q 3/28, H01Q 21/00, H01Q 21/12, H01Q 9/04, H01Q 21/06, H01Q 1/32

(54) **ANTENNENANORDNUNG MIT VERÄNDERLICHER RICHTCHARAKTERISTIK**
ANTENNA ARRANGEMENT WITH VARIABLE DIRECTION CHARACTERISTIC
SYSTÈME D'ANTENNES À CARACTÉRISTIQUE DIRECTIONNELLE VARIABLE

(30) Priorität: 06.03.2013 DE 102013203789
(43) Veröffentlichungstag der Anmeldung: 13.01.2016
(73) Patentinhaber: Robert Bosch GmbH, 70442 Stuttgart (DE)
(72) Erfinder: MAYER, Marcel, 71229 Leonberg (DE); BAUR, Klaus, 88487 Mietingen (DE); HELLINGER, Raphael, 75181 Pforzheim (DE)
(86) Internationale Anmeldenummer: PCT/EP2014/050403
(87) Internationale Veröffentlichungsnummer: WO 2014/135291

(56) Entgegenhaltungen:
- DE-A1-102009 029 291
- DE-A1-102010 041 438
- US-A1- 2007 279 303
- HALLBJÖRNER P ET AL: "Millimetre-wave switched beam antenna using multiple travelling-wave patch arrays", IEE PROCEEDINGS: MICROWAVES, ANTENNAS AND PROPAGATION, IEE, STEVENAGE, HERTS, GB, Bd. 152, Nr. 6, 9. Dezember 2005 (2005-12-09), Seiten 551-555, XP006025522, ISSN: 1350-2417, DOI: 10.1049/IP-MAP:20045174

## Beschreibung

Die Erfindung betrifft das Verschwenken einer Richtcharakteristik einer Antennenanordnung. Insbesondere betrifft die Erfindung eine Antennenanordnung für einen Radarsensor.

### Stand der Technik

An einem Kraftfahrzeug kann ein Radarsensor beispielsweise verwendet werden, um einen Abstand zwischen dem Kraftfahrzeug und einem vorausfahrenden Kraftfahrzeug zu bestimmen. In anderen Ausführungsformen können auch andere Objekte in der Umgebung des ersten Kraftfahrzeugs mittels des Radarsensors bestimmt werden. Um eine korrekte Erfassung bzw. Erkennung eines Objekts mittels des Radarsensors sicher zu stellen, sollte eine Längsachse des Radarsensors einen vorbestimmten Winkel zur horizontalen Ebene einnehmen. Weicht der tatsächliche Winkel vom vorbestimmten Winkel ab, beispielsweise wegen einer Beladung des Kraftfahrzeugs vor oder hinter seinem Schwerpunkt, so werden die Radarsignale vom Radarsensor zu weit nach oben oder zu weit nach unten gesendet und man spricht von einem dejustierten Radarsensor.

Eine Möglichkeit zur mechanischen Justage eines Radarsensors ist in DE 19 857 871 C1 gezeigt. Dort wird vorgeschlagen, einen optischen Spiegel am Radarsensor anzubringen und die Lage des Spiegels mittels einer Laserquelle bezüglich einer Längsachse des Kraftfahrzeugs zu bestimmen und gegebenenfalls anzupassen.

DE 10 2007 041 511 A1 beschreibt ein Verfahren zur Bestimmung eines Winkels zwischen einer Längsachse des Radarsensors und einer Längsachse des Kraftfahrzeugs, indem der Radarsensor ein simuliertes Ziel anpeilt.

Beide Vorschläge erfordern ein mechanisches Justieren des Radarsensors, um dessen Senderichtung in den gewünschten Winkel zur Längsachse des Kraftfahrzeugs zu bringen.

DE 10 2010 041 438 A1 zeigt ein Antennensystem für Radarantennen, das auf einer kettenförmigen Anordnung von Strahlungselementen basiert.

Es sind auch Verfahren zur Bestimmung des Winkels zwischen der Längsachse des Radarsensors und der des Kraftfahrzeugs ohne externe Gerätschaften bekannt. Dabei wird allgemein während des Betriebs des Radarsensors das Rückstreuverhalten verschiedener Objekte ermittelt und daraus der Winkel bestimmt. Bei einer folgenden Positionsbestimmung des Zielobjekts kann der solchermaßen ermittelte Winkel miteinbezogen werden, wodurch die Erfassung bzw. Positionierung des Objekts mit verbesserter Genauigkeit gelingen kann.

Bei den von einem Radarsensor verwendeten Sendefrequenzen ist die Verwendung einer so genannten Panelantenne (patch antenna) gebräuchlich. Derartige Antennen lassen sich kostengünstig durch einen strukturierenden Prozess, insbesondere Ätzen, auf einem hochfrequenzfähigen Substrat realisieren. Die Abstrahlung der Hochfrequenz kann beispielsweise von einem einzelnen Strahlungselement (patch) ausgesandt werden. Um eine stärkere Bündelung der abgestrahlten Hochfrequenz zu erreichen, kann durch eine Anordnung mehrerer Strahlungselemente eine größere Apertur und damit eine schmalere Antennenkeule erreicht werden. Sollen alle Strahlungselemente von der gleichen Quelle gespeist werden, so können sie über ein Verteilnetzwerk parallel gespeist oder in Serie angeordnet werden. Eine solche serielle Speisung wird beispielsweise in US 2007/0279303 A1 vorgeschlagen.

Es sind auch Möglichkeiten bekannt, die Hauptkeulenrichtung einer Antennenanordnung durch Überlagerung zu beeinflussen. Dies eröffnet die Möglichkeit, Schwingungen mit unterschiedlichen Frequenzen oder unterschiedlichen Phasen so zu überlagern, dass die Abstrahlrichtung der Hauptkeule der Antennenanordnung in einer vorbestimmten Weise geändert wird. Phasenschieber zur Veränderung der Phase sind jedoch teuer in der Herstellung und wegen ihrer geringen Temperaturstabilität nicht einfach handhabbar. Eine Variation der Frequenz kann zwar die Hauptstrahlrichtung verändern, jedoch ist jeder Frequenz eine andere Hauptstrahlrichtung fest zugeordnet. Auch wirkt sich die Frequenzveränderung üblicherweise nur wenig auf die Hauptabstrahlrichtung aus, sodass die Frequenz für eine ausreichende Verschwenkung der Abstrahlrichtung unter Umständen so weit verändert werden muss, dass sie außerhalb eines erlaubten Frequenzbandes liegt. Dies ist insbesondere für einen Radarsensor für den automobilen Fernbereich von Bedeutung.

Der Erfindung liegt die Aufgabe zugrunde, eine Antennenanordnung und eine Sendeeinrichtung bereitzustellen, die mit geringem Aufwand eine Variation der Hauptabstrahlrichtung unterstützen. Die Erfindung löst diese Aufgabe mittels einer Antennenanordnung, und einer Sendeeinrichtung mit den Merkmalen der unabhängigen Ansprüche. Unteransprüche geben bevorzugte Ausführungsformen wieder.

### Offenbarung der Erfindung

Eine Antennenanordnung umfasst eine erste und eine zweite Panelantenne, die parallel zueinander ausgerichtet sind. Dabei umfasst jede Panelantenne eine lineare Anordnung von Strahlungselementen. Benachbarte Strahlungselemente einer Panelantenne weisen jeweils konstante Abstände zueinander auf und sind miteinander verbunden. Ferner ist eine Verbindungsleitung zwischen benachbarten Enden der beiden Panelantennen vorgesehen und die beiden verbleibenden Enden der Panelantennen sind jeweils zur Übergabe einer elektrischen Schwingung eingerichtet. Dabei sind Abstände zwischen den benachbarten Strahlungselementen der ersten Panelantenne größer als die der zweiten Panelantenne.

Die beiden Panelantennen bilden also die parallelen Schenkel einer U-förmigen Anordnung, wobei die Enden der Anordnung zur Übergabe von elektrischen Schwingungen ausgebildet sind. Die Abstände zwischen den Strahlungselementen jeder Panelantenne sind bevorzugterweise so gewählt, dass sich durch die serielle Anordnung der Strahlungselemente eine Verschwenkung der Abstrahlrichtung aus der Orthogonalen der Ebene, in der die Panelantenne liegt, ergibt. Die Panelantennen sind beidseitig antiparallel angeordnet, so dass die Verschwenkungsrichtungen einander entgegen gesetzt sind. Die Panelantennen sind beidseitig mit Schwingungen der gleichen Frequenz gespeist. Sind die Amplituden beider Schwingungen gleich, so erfolgt insgesamt keine Verschwenkung, überwiegt die Amplitude einer der Schwingungen, so wird die Abstrahlrichtung der gesamten Anordnung in eine zugeordnete Richtung zur Oberseite oder zur Unterseite des U verschwenkt.

Dies erlaubt es, durch eine relativ einfache Manipulation der Amplituden der elektrischen Schwingungen an den beiden Enden der Panelantennen die Abstrahlrichtung zu kontrollieren. Unterschiedliche Frequenzen oder phasenverschobene Schwingungen werden nicht mehr benötigt. Wird die Antennenanordnung an einem Radarsensor an Bord eines Kraftfahrzeugs verwendet, so kann die Hauptabstrahlrichtung in beispielsweise vertikaler Richtung allein auf elektrischem Weg steuerbar sein, wofür eine mechanische Verstellung des Radarsensors bzw. der Antennenanordnung nicht mehr erforderlich ist. Durch entsprechende Verdrehung der Antennenanordnung kann die Variation der Hauptabstrahlrichtung auch in einer anderen Richtung erfolgen, beispielsweise horizontal.

Damit kann insbesondere eine Dejustage einer Antennenanordnung kompensiert werden. In Verbindung mit einer automatischen Dejustageerkennung kann die Hauptstrahlrichtung der Antennenanordnung vollautomatisch optimierbar sein.

In einer bevorzugten Ausführungsform sind die Strahlungselemente auf einem Substrat angeordnet und die Abstände zwischen den Strahlungselementen liegen jeweils im Bereich der halben Wellenlänge einer umzuwandelnden Schwingung im Substrat. Insbesondere kann einer der Abstände oberhalb und der andere unterhalb der halben Wellenlänge liegen, um die antiparallele Neigung der Hauptabstrahlrichtungen der einzelnen Panelantennen möglichst gut auszunutzen.

In einer weiteren Ausführungsform umfasst wenigstens eine der Panelantennen mehrere parallele lineare Anordnungen von Strahlungselementen, die parallel miteinander verschaltet sind. Dadurch kann eine stärkere Bündelung in der Richtung, die orthogonal zur Schwenkung verläuft, erfolgen. Durch die Verbindungsleitung kann die gesamte Apertur aller Strahlungselemente mit nur einer Quelle für elektrische Schwingungen verwendet werden.

Eine Sendeeinrichtung umfasst die beschriebene Antennenanordnung, eine Schnittstelle zur Verbindung mit einer Schwingungsquelle, eine erste Übertragungseinrichtung zur Bereitstellung einer an der Schnittstelle anliegenden Schwingung an die erste Panelantenne, und eine zweite Übertragungseinrichtung zur Bereitstellung der an der Schnittstelle anliegenden Schwingung an die zweite Panelantenne, wobei wenigstens eine der Übertragungseinrichtungen einen variablen Verstärkungsfaktor aufweist.

Dadurch kann eine integrierte Sendeeinrichtung angegeben werden, die durch einfache Anpassung des Verstärkungsfaktors ein Verschwenken der Hauptabstrahlrichtung unterstützt.

In einer bevorzugten Ausführungsform kann der Verstärkungsfaktor einen von zwei Werten annehmen. Dadurch kann die Übertragungseinrichtung besonders einfach aufgebaut sein.

In einer Ausführungsform kann einer der Werte Null sein. In einer weiteren Ausführungsform, die mit der letztgenannten Ausführungsform kombinierbar ist, ist einer der Werte Eins. Dadurch kann die Hauptabstrahlrichtung bereits beeinflusst werden, indem eine oder beide Übertragungseinrichtungen als Schalter ausgelegt sind.

Ferner kann der Verstärkungsfaktor einer der Übertragungseinrichtungen maximal Eins sein. Dadurch kann zur Übertragung ein Abschwächungsglied verwendet werden, das leicht als passive Schaltung aufgebaut werden kann.

Die Sendeeinrichtung kann zusätzlich eine Steuereinrichtung zur Veränderung des Verstärkungsfaktors wenigstens einer der Übertragungseinrichtungen umfassen. In einer weiteren Ausführungsform ist die Steuereinrichtung zur gegenläufigen Veränderung der Verstärkungsfaktoren der beiden Übertragungseinrichtungen eingerichtet.

### Kurze Beschreibung der Figuren

Die Erfindung soll nun mit Bezug auf die beigefügten Figuren genauer beschrieben werden, in denen:
- Fig. 1: eine Sendeeinrichtung mit einer Antennenanordnung;
- Fig. 2: ein Gewinndiagramm der Sendeeinrichtung von Fig. 1, und
- Fig. 3: eine weitere Ausführungsform der Antennenanordnung von Fig. 1
darstellt.

### Genaue Beschreibung von Ausführungsbeispielen

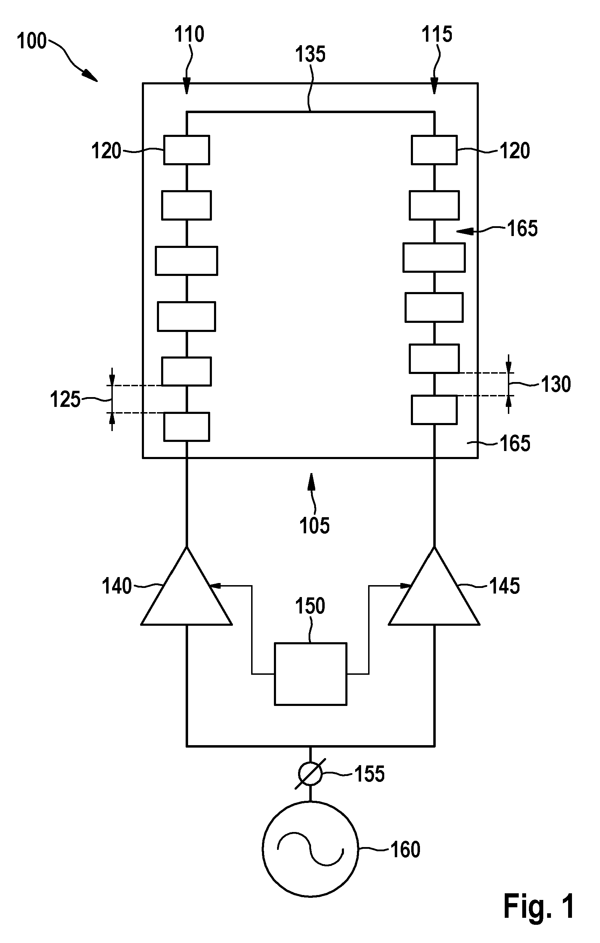

Fig. 1 zeigt eine Sendeeinrichtung 100 mit einer Antennenanordnung 105. Die Antennenanordnung 105 umfasst eine erste Panelantenne 110 und eine zweite Panelantenne 115. Jede Panelantenne 110, 115 umfasst eine Anzahl Strahlungselemente 120. Die Strahlungselemente 120 jeder Panelantenne 110, 115 sind jeweils in einer Reihe angeordnet und galvanisch in Serie miteinander verbunden. Benachbarte Strahlungselemente 120 der ersten Panelantenne 110 weisen jeweils einen ersten Abstand 125, und benachbarte Strahlungselemente 120 der zweiten Panelantenne 115 einen zweiten Abstand 130 auf. Alle ersten Abstände 125 an der ersten Panelantenne 110 und alle Abstände 130 an der zweiten Panelantenne 115 sind untereinander gleich, aber die ersten Abstände 125 sind größer als die zweiten Abstände 130. In einer alternativen Ausführungsform können an Stelle der Abstände 125 und 130 auch Längen von galvanischen Verbindungselementen zwischen jeweils benachbarten Strahlungselementen 120 der unterschiedlichen Panelantennen 110 und 115 in der beschriebenen Weise unterschiedlich lang ausgeführt sein.

Die beiden Panelantennen 110 und 115 liegen parallel nebeneinander und ihre in Fig. 1 oberen Enden sind mittels einer Verbindungsleitung 135 galvanisch miteinander verbunden.

Die Sendeeinrichtung 100 umfasst ferner eine erste Übertragungseinrichtung 140, die mit dem freien, in Fig. 1 unteren Ende der ersten Panelantenne 110 verbunden ist, und eine zweite Übertragungseinrichtung 145, die mit dem zweiten Ende der zweiten Panelantenne 115 verbunden ist. Wenigstens eine der Übertragungseinrichtungen 140, 145 weist einen steuerbaren Verstärkungsfaktor auf. Der Verstärkungsfaktor kann größer Eins sein, wobei die Übertragungseinrichtung einen aktiven Verstärker umfasst, zwischen Null und Eins liegen, wobei die Übertragungseinrichtung ein Dämpfungsglied umfasst, oder alternativ Null oder Eins betragen, wobei die Übertragungseinrichtung einen steuerbaren Schalter umfasst. In der dargestellten Ausführungsform sind beide Übertragungseinrichtungen 140, 145 steuerbar und es ist eine Steuereinrichtung 150 vorgesehen, um die Verstärkungsfaktoren der Übertragungseinrichtungen 140, 145 zu verändern. In einer Ausführungsform erfolgt die Veränderung der Verstärkungsfaktoren gegenläufig.

Eingänge der Übertragungseinrichtungen 140, 145 sind mit einer Schnittstelle 155 verbunden, die dazu eingerichtet ist, eine elektrische Schwingung einer Schwingungsquelle 160 entgegenzunehmen. Die Schwingungsquelle 160 kann auch von der Sendeeinrichtung 100 umfasst sein.

Zur Erläuterung der Funktionsweise der Antennenanordnung 105 soll beispielhaft von einer Sendefrequenz von 76,5 GHz ausgegangen werden. Die Antennenanordnung mit den Panelantennen 110 und 115 sowie der Verbindungsleitung 135 können auf einem Substrat 165 abgeschieden sein, beispielsweise vom Typ Rogers RO 3003. Die Wellenausbreitung im Substrat 165 erfolgt so, dass die Wellenlänge bei der vorgegebenen Frequenz im Bereich von ca. 2,2 mm liegt. Die ersten Abstände 125 sind mit 1,19 mm etwas größer als die halbe Wellenlänge und die zweiten Abstände 130 mit 1,04 mm etwas kleiner.

Sind die Verstärkungsfaktoren der Übertragungseinrichtungen 140, 145 gleich und liefert die Schwingungsquelle 160 die genannte Sendefrequenz, so ist die Hauptabstrahlrichtung der ersten Panelantenne 110 in Fig. 1 aufgrund der gewählten Abstände 125 nach oben, in Richtung der Verbindungsleitung 135 verschwenkt. Die Hauptabstrahlrichtung der zweiten Panelantenne 115 ist aufgrund der gewählten Abstände 130 ebenfalls verschwenkt, jedoch in die entgegengesetzte Richtung, also von der Verbindungsleitung 135 weg. Die von den Panelantennen 110 und 115 abgestrahlten elektromagnetischen Schwingungen überlagern sich derart, dass sich die Verschwenkungen gegenseitig kompensieren und die gemeinsame Hauptabstrahlrichtung orthogonal zur Papierebene liegt.

Ist nun der Verstärkungsfaktor der ersten Übertragungseinrichtung 140 größer als derjenige der zweiten Übertragungseinrichtung 145, so überwiegt der zur Verbindungsleitung 135 hin führende Verschwenkungseffekt und die gemeinsame Hauptabstrahlrichtung ist in diese Richtung geneigt. Ist umgekehrt der Verstärkungsfaktor der zweiten Übertragungseinrichtung 145 größer als der der ersten Übertragungseinrichtung 140, so wird die gemeinsame Hauptabstrahlrichtung der Antennenanordnung 105 von der Richtung der Verbindungsleitung 135 weg verschwenkt.

Die Sendeeinrichtung 100 oder Teile von ihr können in einen Radarsensor, insbesondere zum Einsatz an einem Kraftfahrzeug für den Fernbereich oberhalb von ca. 10 m integriert sein. Ein üblicher Radarsensor kann bereits die Übertragungseinrichtungen 140, 145 und die Schwingungsquelle 160 umfassen, so dass die Implementation der restlichen erforderlichen Elemente mit wenig zusätzlichem Aufwand durchführbar sein kann.

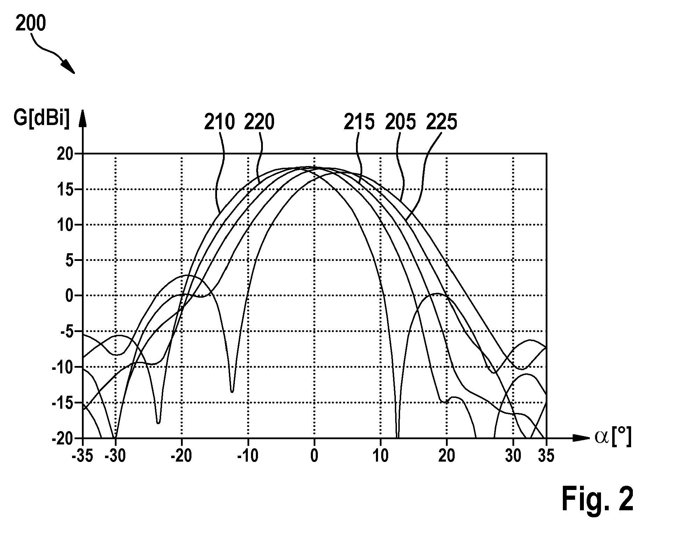

Fig. 2 zeigt ein Gewinndiagramm 200 der Sendeeinrichtung 100 von Fig. 1. In horizontaler Richtung ist ein Schwenkwinkel α in Grad entlang der in Fig. 1 vertikalen Richtung angetragen, in vertikaler Richtung ein Antennengewinn G in dBi.

Eine erste Kurve 205 ergibt sich, wenn der Verstärkungsfaktor der ersten Übertragungseinrichtung 140 mit Eins und der zweite Verstärkungsfaktor der zweiten Übertragungseinrichtung 145 mit Null gewählt ist. Die Hauptabstrahlrichtung liegt dabei bei ca. +4°.

Eine zweite Kurve 210 ergibt sich, wenn der Verstärkungsfaktor der ersten Übertragungseinrichtung 140 mit Null und der Verstärkungsfaktor der zweiten Übertragungseinrichtung 145 mit Eins gewählt wird. Die Hauptabstrahlrichtung liegt in diesem Fall bei ca. -4°.

Eine dritte Kurve 215 ergibt sich, wenn beide Verstärkungsfaktoren mit Eins gewählt werden, die Hauptabstrahlrichtung liegt dann bei ca. 0°.

Wird der Verstärkungsfaktor der ersten Übertragungseinrichtung 140 mit 0,5 und der Verstärkungsfaktor der zweiten Übertragungseinrichtung 145 mit Eins gewählt, so ergibt sich eine vierte Kurve 220, die eine Hauptabstrahlrichtung von ca. -2° aufweist.

Wird hingegen der Verstärkungsfaktor der ersten Übertragungseinrichtung 140 mit Eins und der Verstärkungsfaktor der zweiten Übertragungseinrichtung 145 mit 0,5 gewählt, so ergibt sich eine fünfte Kurve 225, deren Hauptabstrahlrichtung bei ca. +2° liegt.

Mit dem gewählten Beispiel kann also eine Schwenkung der Hauptabstrahlrichtung der Antennenanordnung 105 bzw. der Sendeeinrichtung 100 um ca. ±4° durchgeführt werden. Dabei sind die gewählten Verstärkungsfaktoren einfach zu erzielen und erfordern nur geringen schaltungstechnischen Aufwand.

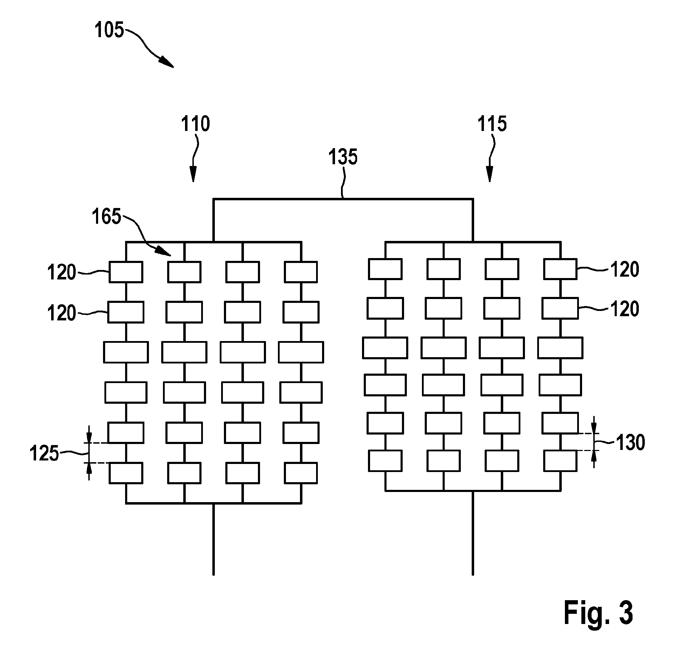

Fig. 3 zeigt eine weitere Ausführungsform der Antennenanordnung 105 von Fig. 1. Jede Panelantenne 110, 115 besteht jeweils aus einer Anzahl parallel angeordneter und parallel miteinander verschalteter Panelantennen entsprechend der Darstellung von Fig. 1. Dabei entsprechen die Abstände benachbarter Strahlungselemente 120 in den einzelnen Serien der ersten Panelantenne 110 dem ersten Abstand 125 und die der Strahlungselemente 120 der zweiten Panelantenne 115 dem zweiten Abstand 130 aus Fig. 1.

Durch die oben beschriebene Steuerung kann die Hauptabstrahlrichtung der Antennenanordnung 105 in der in Fig. 3 vertikalen Richtung elektrisch verstellt werden. Durch die Parallelschaltung mehrerer Serien von Strahlungselementen 120 zu einer ersten Panelantenne 110 bzw. einer zweiten Panelantenne 115 kann eine Richtwirkung in Fig. 1 horizontaler Richtung verbessert sein. Außerdem kann eine vergrößerte Apertur der Antennenanordnung 105 nutzbar sein.

## Patentansprüche

1. Antennenanordnung (105) umfassend:
- eine erste (110) und eine zweite Panelantenne (115), die parallel zueinander ausgerichtet sind,
- wobei jede Panelantenne (110, 115) eine lineare Anordnung von Strahlungselementen (120) umfasst,
- wobei benachbarte Strahlungselemente (120) einer Panelantenne (110, 115) jeweils konstante Abstände (125, 130) aufweisen und miteinander verbunden sind;
- eine Verbindungsleitung (135) zwischen benachbarten Enden der Panelantennen (110, 115);
- wobei die beiden verbleibenden Enden der Panelantennen (110, 115) jeweils zur Übergabe einer elektrischen Schwingung eingerichtet sind,
- wobei Abstände (125) zwischen den benachbarten Strahlungselementen (120) der ersten Panelantenne (110) größer als die (130) der zweiten Panelantenne (115) sind,
**gekennzeichnet durch**
- eine Schnittstelle (155) zur Verbindung mit einer Schwingungsquelle (160);
- eine erste Übertragungseinrichtung (140) zur Bereitstellung einer an der Schnittstelle (155) anliegenden Schwingung an die erste Panelantenne (110), und
- eine zweite Übertragungseinrichtung (145),zur Bereitstellung der an der (155) Schnittstelle anliegenden Schwingung an die zweite Panelantenne (115),
- wobei eine der Übertragungseinrichtungen (140, 145) einen variablen Verstärkungsfaktor aufweist;
- und eine Steuereinrichtung (150) zur Veränderung des Verstärkungsfaktors wenigstens einer der Übertragungseinrichtungen (140, 145).

2. Antennenanordnung (105) nach Anspruch 1, wobei die Strahlungselemente (120) auf einem Substrat (165) angeordnet sind und die Abstände (125, 130) zwischen den Strahlungselementen (120) jeweils im Bereich der halben Wellenlänge einer umzuwandelnden Schwingung im Substrat (165) liegen.

3. Antennenanordnung (105) nach Anspruch 1 oder 2, wobei eine der Panelantennen (110, 115) mehrere parallele lineare Anordnungen von Strahlungselementen (120) umfasst, die parallel miteinander verschaltet sind.

4. Sendeeinrichtung (100) nach einem der vorangehenden Ansprüche, wobei der Verstärkungsfaktor einen von zwei Werten annehmen kann.

5. Sendeeinrichtung (100) nach einem der vorangehenden Ansprüche, wobei einer der Werte Null ist.

6. Sendeeinrichtung (100) nach einem der vorangehenden Ansprüche, wobei einer der Werte Eins ist.

7. Sendeeinrichtung (100) nach einem der vorangehenden Ansprüche, wobei der Verstärkungsfaktor einer der Übertragungseinrichtungen (140, 145) maximal Eins ist.

## Claims

1. Antenna arrangement (105) comprising:
- a first (110) and a second panel antenna (115), which are aligned parallel to one another,
- wherein each panel antenna (110, 115) comprises a linear arrangement of radiation elements (120),
- wherein adjacent radiation elements (120) of a panel antenna (110, 115) in each case have constant distances (125, 130) and are connected to one another;
- a connecting line (135) between adjacent ends of the panel antennas (110, 115);
- wherein the two remaining ends of the panel antennas (110, 115) are designed in each case for transferring an electrical oscillation,
- wherein distances (125) between the adjacent radiation elements (120) of the first panel antenna (110) are greater than those (130) of the second panel antenna (115),
**characterized by**
- an interface (155) for connection to an oscillation source (160);
- a first transfer device (140) for providing an oscillation present at the interface (155) to the first panel antenna (110), and
- a second transfer device (145) for providing the oscillation present at the interface (155) to the second panel antenna (115),
- wherein one of the transfer devices (140, 145) has a variable gain factor;
- and a control device (150) for varying the gain factor of at least one of the transfer devices (140, 145).

2. Antenna arrangement (105) according to Claim 1, wherein the radiation elements (120) are arranged on a substrate (165) and the distances (125, 130) between the radiation elements (120) are in each case in the range of half the wavelength of an oscillation to be converted in the substrate (165).

3. Antenna arrangement (105) according to Claim 1 or 2, wherein one of the panel antennas (110, 115) comprises a plurality of parallel linear arrangements of radiation elements (120) which are interconnected in parallel with one another.

4. Transmitting device (100) according to any of the preceding claims, wherein the gain factor can assume one of two values.

5. Transmitting device (100) according to any of the preceding claims, wherein one of the values is zero.

6. Transmitting device (100) according to any of the preceding claims, wherein one of the values is one.

7. Transmitting device (100) according to any of the preceding claims, wherein the gain factor of one of the transfer devices (140, 145) is a maximum of one.

## Revendications

1. Système d'antenne (105) comprenant :
- des première (110) et seconde (115) antennes panneaux orientées parallèlement l'une à l'autre,
- dans lequel chaque antenne panneau (110, 115) comprend un agencement linéaire d'éléments rayonnants (120),
- dans lequel des éléments rayonnants voisins (120) d'une antenne panneau (110, 115) présentent respectivement des écartements constants (125, 130) et sont reliés les uns aux autres ;
- une ligne de connexion (135) entre des extrémités adjacentes des antennes panneaux (110, 115) ;
- dans lequel les deux extrémités restantes des antennes panneaux (110, 115) sont respectivement conçues pour transmettre une oscillation électrique,
- dans lequel les écartements (125) entre les éléments rayonnants voisins (120) de la première antenne panneau (110) sont supérieurs à ceux (130) de la seconde antenne panneau (115),
**caractérisé par**
- une interface (155) de connexion à une source d'oscillation (160) ;
- un premier dispositif de transmission (140) destiné à fournir une oscillation appliquée à l'interface (155) à la première antenne panneau (110), et
- un second dispositif de transmission (145) destiné à fournir l'oscillation appliquée à l'interface (155) à la seconde antenne panneau (115),
- dans lequel l'un des dispositifs de transmission (140, 145) présente un facteur d'amplification variable ;
- et un dispositif de commande (150) destiné à modifier le facteur d'amplification d'au moins l'un des dispositifs de transmission (140, 145).

2. Système d'antenne (105) selon la revendication 1, dans lequel les éléments rayonnants (120) sont disposés sur un substrat (165) et les écartements (125, 130) entre les éléments rayonnants (120) se situent respectivement dans un intervalle égal à une moitié de longueur d'onde d'une oscillation devant être convertie dans le substrat (165).

3. Système d'antenne (105) selon la revendication 1 ou 2, dans lequel l'une des antennes panneaux (110, 115) comprend une pluralité d'agencements linéaires parallèles d'éléments rayonnants (120) connectés les uns aux antres en parallèle.

4. Dispositif d'émission (100) selon l'une quelconque des revendications précédentes, dans lequel le facteur d'amplification peut prendre deux valeurs.

5. Dispositif d'émission (100) selon l'une quelconque des revendications précédentes, dans lequel l'une des valeurs est nulle.

6. Dispositif d'émission (100) selon l'une quelconque des revendications précédentes, dans lequel l'une des valeurs est égale à 1.

7. Dispositif d'émission (100) selon l'une quelconque des revendications précédentes, dans lequel le facteur d'amplification de l'un des dispositifs de transmission (140, 145) est au maximum égal à 1.
